# EUROPEAN PATENT SPECIFICATION

(11) **EP 2 490 222 B1**
(45) Date of publication and mention of the grant of the patent: **11.01.2017**
(21) Application number: 12155499.2
(22) Date of filing: 15.02.2012
(51) Int. Cl.: G11C 11/405, G11C 7/02, G11C 11/4097, G11C 7/18

(54) **Memory cell and memory array utilizing the memory cell**
Speicherzelle und Speicheranordnung mit der Speicherzelle
Cellule de mémoire et réseau de mémoire utilisant la cellule de mémoire

(30) Priority: 17.02.2011 EP 11154812
(43) Date of publication of application: 22.08.2012
(73) Proprietor: Nanya Technology Corporation, Fushing 3 Rd., Kueishan T'ao yuan (TW)
(72) Inventor: Ting, Tah-Kang Joseph, Tapei City 111 (TW)
(74) Representative: Becker Kurig Straus

(56) References cited:
- US-A1- 2003 062 905
- US-A1- 2003 151 943
- US-A1- 2011 002 159

## Description

### Field of the Invention

The present invention relates to a memory array according to the pre-characterizing clauses of claim 1.

### Background of the Invention

A conventional dynamic random-access memory (DRAM) cell includes a bit line, a word line, a switch device (usually a transistor) and a capacitor. The capacitor is utilized to store data when it is charged or discharged (logic value 0 or 1). The switch device is turned on or off via a word line. The bit line is utilized to transmit the data read from the capacitor of the memory cell, or the data written to the capacitor, when the memory cell is turned on by the switch device.

With the advancement of semiconductor manufacturing technologies, the sizes of semiconductor devices are shrinking. Accordingly, the sizes of DRAM cells are also becoming smaller, thus significantly reducing the distances between bit lines. As a result, adjacent bit lines may suffer an undesirable coupling effect and generate noise to each other. As a result, data transmitted by bit lines in such a device may therefore be wrongly determined. For example, data having a value of "0"may be wrongly determined as having a value of "1", and data having a value of "1" maybe wrongly determined as having a value of "0".

US 2003/0062905 A1 (KOLLMER UTE [DE] ET AL) 3 April 2003 (2003-04-03) discloses: a circuit configuration for assessing capacitances in a matrix, which has a number of rows with at least one capacitance in at least one dimension, includes a test arm connected to first electrodes of each of the capacitances to be assessed and by which two different potentials can be applied to the first electrodes, a measurement arm connected to second electrodes of each of the capacitances to be assessed and that has a first measurement path and a second measurement path connected to a common potential. The first measurement path has an instrument for assessing the capacitances and the first and second measurement paths can be connected to the second electrodes. The circuit configuration has a drive device that connects each of the capacitances to be assessed individually to the two different potentials.

US 2011/0002159 A1 (SUZUKI RYOTA [JP] ET AL) 6 January 2011 (2011-01-06) discloses a memory array excellent in noise characteristics and small in size and a semiconductor integrated circuit device having such a memory array. Memory cells each have two transistors and one storage element connected in series in this order between a corresponding one of bit lines and a constant voltage. The two transistors respectively have gate electrodes respectively connected to a corresponding one of first word lines and a corresponding one of second word lines. A memory array includes mats each having the memory cells disposed at all intersections between the bit lines and the first word lines, sense amplifiers each input with a corresponding pair of the bit lines in the same mat as a bit line pair, and first and second word drivers adapted to activate the first and second word lines, respectively.

US 2003/0151943 A1 (SADAKATA HIROYUKI [JP]) 14 August 2003 (2003-08-14) discloses a folded bitline type sense amplifier circuit is disposed at an outer side of an end memory cell array in which 2Tr1 C type cells each composed of a data storage capacitor, an A port access transistor and a B port access transistor are arranged in the form of a matrix, and two word lines used for cell selection are connected to corresponding gates of the A and B port access transistors. The drain of the A port access transistor is connected to one bit line of an open bitline type sense amplifier circuit, and the drain of the B port access transistor is connected to one bit line out of a bit line pair of the folded bitline sense amplifier circuit.

### Summary of the Invention

This in mind, the present invention aims at providing a memory array.
This is achieved by a memory array according to claim 1. The dependent claims pertain to corresponding further development and improvements.

As will be seen more clearly from the detailed description below, the memory cell includes a first switch device, a second switch device and a capacitor. The first switch device has a control terminal coupled to a select line, wherein the first switch device is controlled by the select line to be turned on or turned off, a first terminal coupled to a bit line parallel with the select line, and a second terminal. The second switch device has a first terminal coupled to the second terminal of the first switch device, a control terminal coupled to a word line orthogonal to the bit line and the select line, wherein the word line is controlled to turn on or turn off the second switch device, and a second terminal. The capacitor has a first terminal coupled to the second terminal of the second switch device and a second terminal coupled to a predetermined voltage level, wherein the data is read from the capacitor or written to the capacitor via the bit line.

Additionally, the memory array includes a plurality of the memory cells, wherein the memory cells in the memory array can be classified into multiple groups of memory cells, and the data lines of the memory array are arranged in a way that no adjacent data lines are from the same group of memory cells. In this arrangement, the memory operation can be designed such that when the data lines of one of the multiple groups of memory cells are transmitting data, the data lines of the other groups of memory cells are not transmitting data. In this way, the noise coupling effect between data lines is minimized.

### Brief Description of the Drawings

In the following, the invention is further illustrated by way of example, taking reference to the accompanying drawings. Thereof
FIG.1 is a circuit diagram illustrating a memory cell according to one exemplary embodiment of the present invention;
FIG.2 is a schematic diagram illustrating an exemplary semiconductor structure and manufacturing process thereof for forming a bit line BL according to an embodiment of the present invention in the circuit diagram depicted in FIG.1 ;
FIG.3 is a schematic diagram illustrating an exemplary semiconductor structure and manufacturing process thereof for forming a select line SL according to an embodiment of the present invention in the circuit diagram depicted in FIG.1;
FIG.4 is a schematic diagram illustrating an exemplary semiconductor structure and manufacturing process thereof for forming a word line WL according to an embodiment of the present invention in the circuit diagram depicted in FIG.1;
FIG.5 is a schematic diagram illustrating an exemplary semiconductor structure and manufacturing process thereof for forming a capacitor C according to an embodiment of the present invention in the circuit diagram depicted in FIG.1; and
FIG.6 is a circuit diagram illustrating a memory array according to one exemplary embodiment of the present invention.

### Detailed Description

Certain terminologies are used throughout the description and following claims to refer to particular components. As one skilled in the art will appreciate, electronic equipment manufacturers may refer to a component by different terms. This document does not intend to distinguish between components that differ in terms but not function. In the following description and in the claims, the terms "include" and "comprise" are used in an open-ended fashion, and thus should be interpreted to mean "include, but not limited to...". Also, the term "couple" is intended to mean either an indirect or direct electrical connection. Accordingly, if one device is coupled to another device, that connection may be through a direct electrical connection, or through an indirect electrical connection via other devices and connections. Please note that a DRAM is utilized for explaining the following embodiments. The following embodiments are, nevertheless, applicable to other types of memory devices.

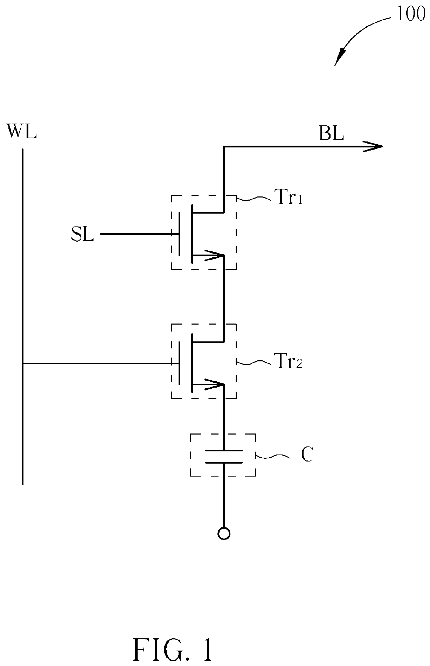

Please refer to FIG.1, which is a circuit diagram illustrating a memory cell 100 according to an exemplary embodiment of the present invention. As shown in FIG.1, the memory cell 100 includes a first switch device Tr₁, a second switch device Tr₂ and a capacitor C coupled in series between a bit line BL and a predetermined voltage level. The first switch device Tr₁ includes a control terminal coupled to a select line SL. The first switch device Tr₁ is turned on or off according to the potential of the select line SL. A first terminal of the first switch device Tr₁ is coupled to a bit line BL.

The second switch device Tr₂ includes a control terminal coupled to a word line WL, and is turned on or off according to the potential of the word line WL. A first terminal of the second switch device Tr₂ is coupled to a second terminal of the first switch device Tr₁ (in this embodiment, they are directly connected). The capacitor C includes a first terminal coupled to a second terminal of the second switch device Tr₂, and a second terminal coupled to a receive a predetermined voltage level. The capacitor C is for storing data, and the data is read from the capacitor C or written to the capacitor C via the bit line BL when both the first switch device Tr₁ and the second switch device Tr₂ are turned-on. Please note that the embodiment shown in FIG.1 of the present invention includes a physical-structure feature: the bit line BL is parallel with the select line SL. Also, the word line WL is orthogonal to the bit line BL and the select line SL.

A conventional DRAM memory cell has only the second switch device Tr₂ and the capacitor C. When the second switch device Tr₂ is turned-on, the bit line BL is electronically connected to the capacitor C and can transmit data to the capacitor C or read data from the capacitor C. If, however, the memory cell further includes the first switch device Tr₁ as is shown in the present invention, the bit line BL will transmit no data and remain silent when the first switch device Tr₁ is turned-off, even if the second switch device Tr₂ is turned-on. To make the connection between bit line BL and the capacitor C, the first switch device Tr₁ must also be turned-on.

Also, transistors such as an n-channel metal-oxide field-effect transistor (nMOSFET) can be implemented as switch devices Tr₁ and Tr₂. In this case, first terminals of the first and the second switch devices Tr₁ and Tr₂ are drain terminals, control terminals of the first and the second switch devices Tr₁ and Tr₂ are gate terminals, and the second terminals of the first and the second switch devices Tr₁ and Tr₂ are source terminals. Please note that this example is not intended to limit the scope of the present invention. For example, other devices that can be utilized as switch devices, such as a p-channel metal-oxide field-effect transistor (pMOSFET) or a bipolar junction transistor (BJT), can also be the switch devices Tr₁ and Tr₂.

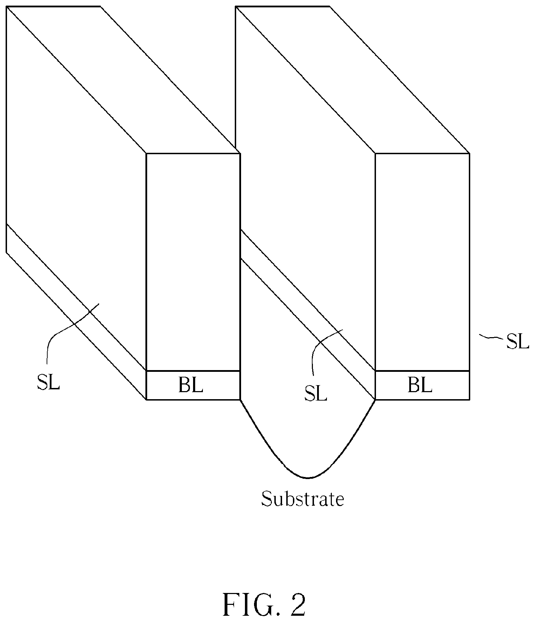

FIGs 2-5 are schematic diagrams illustrating an exemplary semiconductor structure and manufacturing process thereof for the circuit diagram depicted in FIG.1. Please note that the process and the semiconductor structure shown in FIGs.2-5 are only for example and do not mean to limit that the memory cell shown in FIG.1 can only be manufactured based on the semiconductor structures and processes in FIGs.2-5.

One exemplary process for manufacturing the semiconductor structure is explained as below. Please note that the procedure shown in FIG.2-FIG.5 focuses on the processes for manufacturing the bit lines BL, the select lines SL and the word lines WL. The processes for manufacturing other devices such as transistors are omitted for brevity here, since they are known by persons skilled in the art.

In FIG.2, the bit line BL is formed, which can include the steps of: bit line lithography, bit line etching, implanting, annealing and isolation etching. For example, during BL formation, an oxide film and a nitride film are grown on the entire surface of a silicon substrate (not illustrated). Then, the nitride film is patterned in conformity with switch devices forming portions. Using the patterned nitride film as a mask, etching is carried out to form silicon lines. Then, the silicon lines are subjected to side-surface oxidation and formed with a nitride film and then, by entire-surface etch back, a sidewall is formed. Thereafter, arsenic (As), phosphorus (P), or the like is implanted at the root of the silicon lines and followed by annealing to form a buried diffusion layer which will serve as bit lines BL.

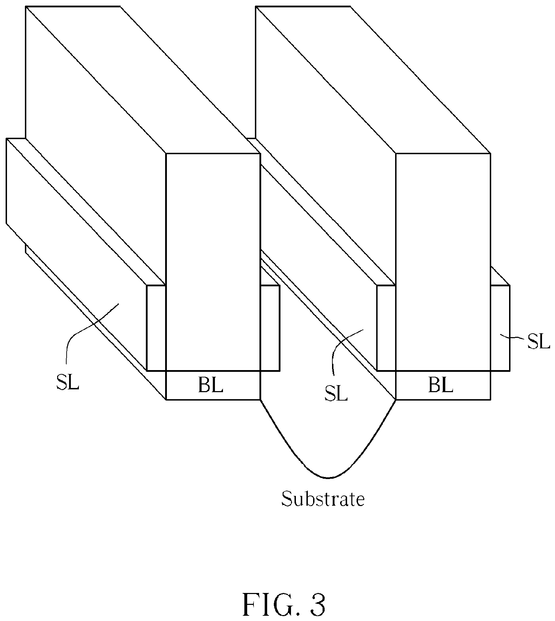

In FIG.3, the select line SL is formed, which can include the steps of oxide filling, recessing, gate oxide providing, metal liner producing, dry etching, oxide filling again and CMP. For example, during SL formation, the sidewall nitride film is removed by oxide film etching and nitride film etching. Oxide refill and recess to define bottom height of SL. Gate insulating films and gate electrodes are formed and subjected to etch back, thereby forming the select lines SL to first switch device Tr₁ on lower side surfaces of the silicon pillars in the same direction of the buried bit lines BL. Please note an isolation material can be provided (not illustrated here) between the select lines SL and the bit lines BL to prevent these two devices from touching each other.

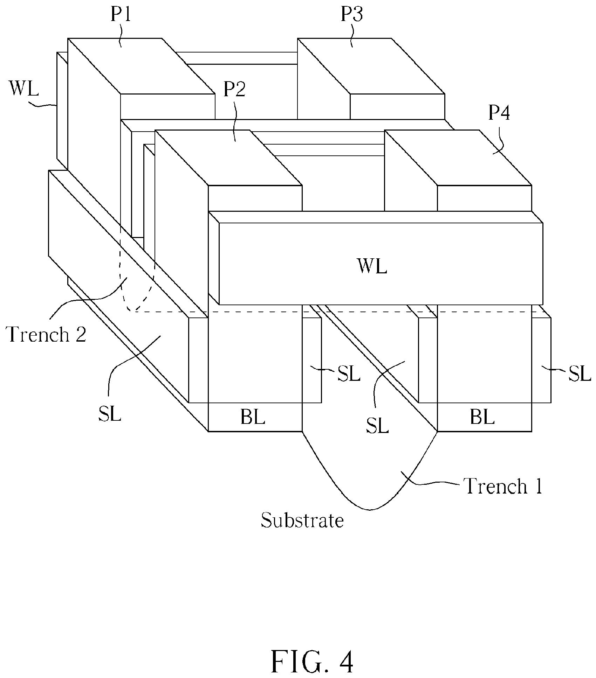

In FIG.4, the word line WL is formed, which may includes the steps of: word line lithography, word line etching, gate oxide providing, and metal liner producing. For example, during the WL formation, WL lithography and an etching process may be used to form Silicon pillars, followed by gate oxide formation. Metal liner deposition on the entire wafer and etch back can then be used to remove top and bottom metal liners. Next a WL sidewall is formed. Thereafter, arsenic (As), phosphorus (P), or the like is implanted and then word lines WL to second switch device Tr₂ are formed on upper side surfaces of the silicon pillars in a direction perpendicular to the buried bit lines BL. The silicon pillars P1, P2, P3, P4, in FIG.4 are generated from the structure shown in FIG.3 via etching. Therefore a Trench 2 indicated by dotted lines is formed between the silicon pillars P1, P2 and between the silicon pillars P3 and P4. If it is looked from the left side of FIG.4, the shape of Trench 2 looks like which of Trench 1 formed on the substrate.

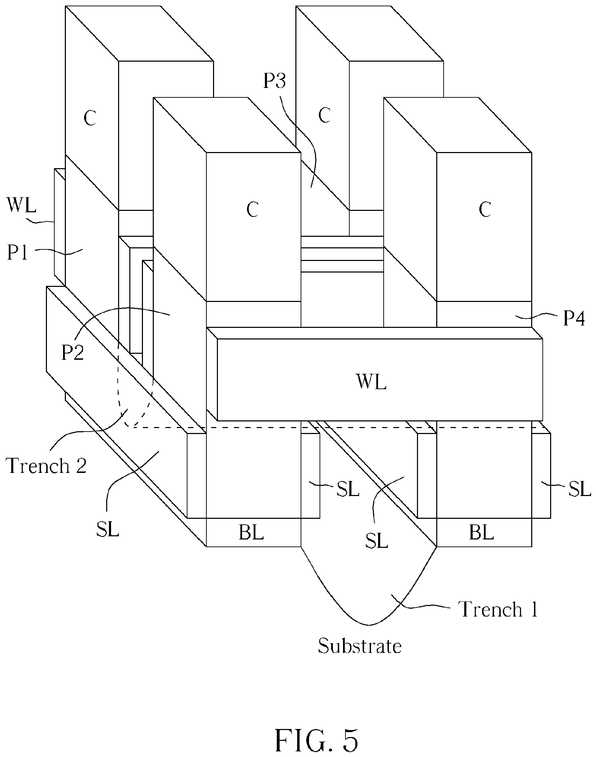

In FIG.5, the capacitor C is formed, an interlayer oxide film is formed up to the top of the silicon pillars and then the nitride film on the silicon pillars is removed. Then, arsenic (As), phosphorus (P), or the like is implanted to form an N+ diffusion layer. Thereafter, capacitor contacts for capacitor connection and capacitors C are formed.

Via the brief steps disclosed in FIG.2-FIG.5, the word line, the bit line BL, and the select line SL can be formed. Please note many details or substitute steps are not illustrated here, persons skilled in the art can understand that the semiconductor and the manufacturing process that can be implemented to the memory cell shown in FIG.1 are not limited to what disclosed in FIG.2-FIG.5.

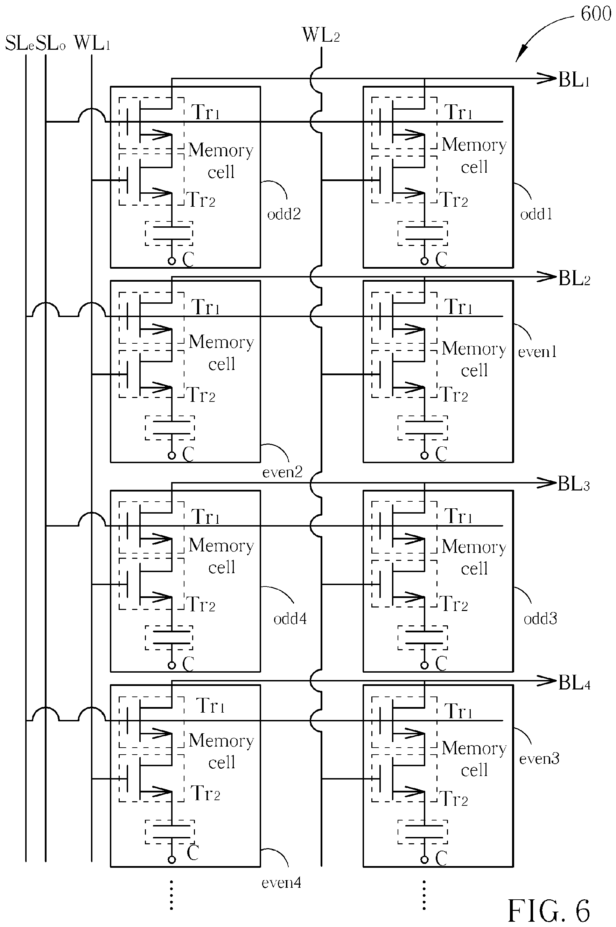

Please refer to FIG.6, which illustrates a memory array 600 utilizing memory cells illustrated in FIG.1, according to one embodiment of the present invention. As shown in FIG.6, the memory array 600 includes a plurality of memory cells odd₁-odd₄, and even₁-even₄. Each of the memory cells odd₁-odd₄, even₁-even₄ includes a first switch device Tr₁, a second switch device Tr₂ and a capacitor C, as in the memory cell shown in FIG.1. Also, please note that the memory array according to the present invention may have the memory cell provided at each intersection of the bit lines and word lines. In one embodiment, the memory cells odd₁-odd₄, and even₁-even₄ can be classified into odd memory cells (odd₁, odd₂, odd₃, odd₄) and even memory cells (even₁, even₂, even₃, even₄). Please note the column select lines SLₒ, SLₑ are the select line SL in FIG.1, but are named column select lines and classified into odd select lines SLₒ and even select lines SLₑ in this embodiment) respectively serve to control the first switch devices Tr₁ in the odd memory cells and the even memory cells. The odd memory cells odd₁, odd₂, odd₃, odd₄ are controlled by the column select line SLo and the word lines WL₁, WL₂. The even memory cells even₁, even₂, even₃ and even₄ are controlled by the column select line SLₑ, and the word lines WL₁, WL₂.

In one embodiment, when the bit lines BL₁, BL₃ of the odd memory cells odd₁, odd₂, odd₃, odd₄ are transmitting data, the first switch devices Tr₁ in the even memory cells even₁, even₂, even₃, even₄ are controlled by the column select line SLₑ to be turned-off, such that the bit lines BL₂, BL₄ of the even memory cells even₁, even₂, even₃, even₄ cease transmitting data and keep silent. Similarly, when the bit lines BL₂,BL₄ of the even memory cells even₁, even₂, even₃, even₄ are transmitting data (ex. in a sensing stage), the first switch devices Tr₁ in the odd memory cells odd₁, odd₂, odd₃ and odd₄ are controlled by the column select line SLₒ to be turned-off, such that the bit lines BL₁, BL₃ cease transmitting data and keep silent.

In this way, the bit line that ceases transmitting data can be utilized as shielding for the bit line that transmits data, thus the two or more bit lines transmitting data can be prevented from disturbing to each other since there is a shielding located between two active bit lines.

In view of the above mentioned embodiment shown in FIG.6, the memory array according to the present invention can be summarized as follows:
The memory cells in the memory array can be classified into a first group of memory cells and a second group of memory cells, and the bit lines of the memory array are arranged in a way that no adjacent bit lines are from the same group of memory cells. In this arrangement, the memory operation can be designed such that when the bit lines of one of the two groups of memory cells are transmitting data, the bit lines of the other group of memory cells are not transmitting data. In this way, the noise coupling effect between bit lines is minimized.

It should be noted that the structure shown in FIG.6 does not mean to limit the scope of the present application. For example, the memory cells in the memory array can be classified into more than two groups. Furthermore, the operation of the memory array is not limited to be the same as above-mentioned operation.

In view of above-mentioned embodiments, the memory cell according to present invention can downsize the circuit region since it has a 3D structure. Also, the noise coupling effect between two adjacent bit lines can be minimized. In addition, the memory cells disclosed in the present invention can be utilized for folded bit lines.

All combinations and sub-combinations of the above-described features also belong to the invention.

## Claims

1. A memory array (600), comprising:
a plurality of memory cells (odd1-odd4, even1-even4), wherein each of the memory cells comprises:
a first switch device (Tr1), having:
a control terminal coupled to a column select line (SLe, SLo), wherein the first switch device (Tr1) is controlled by the column select line (SLe, SLo) to be turned-on or turned-off;
a first terminal, coupled to a bit line (BL1-BL4); and
a second terminal;
a second switch device (Tr2), having:
a first terminal, coupled to the second terminal of the first switch device (Tr1);
a control terminal coupled to a word line (WL1, WL2)
wherein the second switch device (Tr2) is controlled by the word line (WL1, WL2) to be turned-on or turned-off; and
a second terminal; and
a capacitor (C), having a first terminal coupled to the second terminal of the second switch device (Tr2) and a second terminal coupled to a predetermined voltage level, wherein data is read from the capacitor (C) or written to the capacitor via the bit line (BL1-BL4);
the memory array (600) **characterized in that**
the bit line (BL1-BL4) is parallel with the column select line (SLe, SLo); and
the word line (WL1, WL2) is orthogonal to the bit line (BL1-BL4) and the column select line (SLe, SLo).

2. The memory array of claim 1, **characterized in that** the memory cells in the memory array are classified into multiple groups of memory cells, and the bit lines (BL1-BL4) of the memory array are arranged in a way that no adjacent bit lines are from the same group of memory cells, when the bit lines (BL1-BL4) of one of the multiple groups of memory cells are transmitting data, the bit lines of the other groups of memory cells are not transmitting data.

3. The memory array of claim 1, **characterized in that** the second terminal of the first switch device (Tr1) is directly connected to the first terminal of the second switch device (Tr2).

4. The memory array of claim 1, **characterized in that** the first switch device (Tr1) and the second switch device (Tr2) are nMOSFETs, where the first terminals of the first switch device (Tr1) and the second switch device (Tr2) are drain terminals, the control terminals of the first switch device (Tr1) and the second switch device (Tr2) are gate terminals, and the second terminals of the first switch device (Tr1) and the second switch device (Tr2) are source terminals.

5. The memory array of claim 1, **characterized in that** the first switch device (Tr1) and the second switch device (Tr2) are pMOSFETs, where the first terminals of the first switch device (Tr1) and the second switch device (Tr2) are source terminals, the control terminals of the first switch device (Tr1) and the second switch device (Tr2) are gate terminals, and the second terminals of the first switch device (Tr1) and the second switch device (Tr2) are drain terminals.

6. The memory array of claim 1, **characterized in that** a memory cell (odd1-odd4, even1-even4) is provided at each intersection of the bit lines (BL1-BL4) and the word lines (WL1, WL2).

## Patentansprüche

1. Speicher-Array (600), welcher umfasst:
mehrere Speicher-Zellen (odd1-odd4, even-even4), worin jeder der Speicher-Zellen umfasst:
eine erste Umschalteinrichtung (Tr1), mit:
einem Steuer-Anschluss, der mit einer Spaltenauswahl-Line (SLe, SLo) gekoppelt ist, worin die erste Umschalteinrichtung (Tr1) durch die Spaltenauswahl-Line (SLe, SLo) angeschaltet oder ausgeschaltet wird;
einem ersten Anschluss, der mit einer Bit-Line (BL1-BL4) gekoppelt ist; und
einem zweiten Anschluss;
eine zweite Umschalteinrichtung (Tr2), mit:
einem ersten Anschluss, der mit dem zweiten Anschluss der ersten Umschalteinrichtung (Tr1) gekoppelt ist;
einem Steuer-Anschluss, der mit einer Wort-Line (WL1, WL2) gekoppelt ist, worin die zweite Umschalteinrichtung (Tr2) durch die Wort-Line (WL1, WL2) angeschaltet oder abgeschaltet wird; und
einem zweiten Anschluss; und
einen Kondensator (C), mit einem ersten Anschluss, der mit dem zweiten Anschluss der zweiten Umschalteinrichtung (Tr2) gekoppelt ist, und mit einem zweiten Anschluss, der mit einem bestimmten Spannungsniveau gekoppelt ist, worin Daten über die Bit-Line (BL1-BL4) von dem Kondensator (C) gelesen oder auf den Kondensator geschrieben werden;
worin der Speicher-Array (600) **dadurch gekennzeichnet ist, dass** die Bit-Line (BL1-BL4) parallel zu der Spaltenauswahl-Line (SLe, SLo) ist; und
worin die Wort-Line (WL1, WL2) orthogonal zu der Bit-Line (BL1-BL4) und der Spaltenauswahl-Line (SLe, SLo) ist.

2. Speicher-Array nach Anspruch1, **dadurch gekennzeichnet, dass** die Speicher-Zellen in dem Speicher-Array in mehrere Speicher-Zellen-Gruppen klassifiziert sind, und dass die Bit-Lines (BL1-BL4) des Speicher-Arrays in einer Art und Weise angeordnet sind, dass benachbarte Lines nicht von der gleichen Speicher-Zellen-Gruppe sind, wenn die Bit-Lines (BL1-BL4) einer der mehreren Speicher-Zellen-Gruppen Daten übermitteln und die Bit-Lines der anderen Speicher-Zellen-Gruppen keine Daten übermitteln.

3. Speicher-Array nach Anspruch 1, **dadurch gekennzeichnet, dass** der zweite Anschluss der ersten Umschalteinrichtung (Tr1) direkt mit dem ersten Anschluss der zweiten Umschalteinrichtung (Tr2) verbunden ist.

4. Speicher-Array nach Anspruch1, **dadurch gekennzeichnet, dass** die erste Umschalteinrichtung (Tr1) und die zweite Umschalteinrichtung (Tr2) nMOSFETs sind, wobei die ersten Anschlüsse der ersten Umschalteinrichtung (Tr1) und der zweiten Umschalteinrichtung (Tr2) Abfluss-Anschlüsse sind, die Steuer-Anschlüsse der ersten Umschalteinrichtung (Tr1) und der zweiten Umschalteinrichtung (Tr2) Gate-Anschlüsse sind, und die zweiten Anschlüsse der erste Umschalteinrichtung (Tr1) und der zweiten Umschalteinrichtung (Tr2) Source-Anschlüsse sind.

5. Speicher-Array nach Anspruch1, **dadurch gekennzeichnet, dass** die erste Umschalteinrichtung (Tr1) und die zweiten Umschalteinrichtung (Tr2) pMOSFETs sind, wobei die ersten Anschlüsse der erste Umschalteinrichtung (Tr1) und der zweiten Umschalteinrichtung (Tr2) Source-Anschlüsse sind, die Steuer-Anschlüsse der erste Umschalteinrichtung (Tr1) und der zweiten Umschalteinrichtung (Tr2) Gate-Anschlüsse sind, und die zweiten Anschlüsse der erste Umschalteinrichtung (Tr1) und der zweiten Umschalteinrichtung (Tr2) Drain-Anschlüsse sind.

6. Speicher-Array nach Anspruch1, **dadurch gekennzeichnet, dass** an jedem Schnittpunkt der Bit-Lines (BL1-BL4) und der Wort-Lines (WL1, WL2) ein Speicherzelle (oddl-odd4, even1-even4) vorgesehen ist.

## Revendications

1. Tableau de mémoire (600), comprenant :
une pluralité de cellules de mémoire (odd1-odd4, even1-even4), dans lequel chacune des cellules de mémoire comprend :
un premier dispositif de switch (Tr1) présentant :
un terminal de commande couplé à une ligne de sélection de colonne (SLe, SLo), dans lequel le premier dispositif de switch (Tr1) est commandé par la ligne de sélection de colonne (SLe, SLo) pour être mis en marche ou arrêté ;
un premier terminal, couplé à une ligne de bits (BL1-BL4) ;
et
un second terminal ;
un second dispositif de switch (Tr2), présentant :
un premier terminal, couplé au second terminal du premier dispositif de switch (Tr1) ;
un terminal de commande couplé à une ligne de mots (WL1, WL2)
dans lequel
le second dispositif de switch (Tr2) est commandé par la ligne de mots (WL1, WL2) pour être mis en marche ou arrêté ; et
un second terminal ; et
un condensateur (C) présentant un premier terminal couplé au second terminal du second dispositif de switch (Tr2) et un second terminal couplé à un niveau de tension prédéterminé, dans lequel des données sont lues à partir du condensateur (C) ou écrites au condensateur (C) par le biais de la ligne de bits (BL1-BL4) ;
le tableau de mémoire (600) étant **caractérisé en ce que**
la ligne de bits (BL1-BL4) est parallèle à la ligne de sélection de colonne (Sle, Slo) ; et
la ligne de mots (WL1, WL2) est orthogonale à la ligne de bits (BL1-BL4) et à la ligne de sélection de colonne (Sle, Slo).

2. Tableau de mémoire selon la revendication 1, **caractérisé en ce que** les cellules de mémoire dans le tableau de mémoire sont classées en des groupes multiples de cellules de mémoire, et les lignes de bits (BL1-BL4) du tableau de mémoire sont agencées de façon à ce qu'aucune ligne de bits adjacente ne vienne du même groupe de cellules de mémoire, lorsque les lignes de bits (BL1-BL4) de l'un des groupes multiples de cellules de mémoire transmettent des données, les lignes de bits des autres groupes de cellules de mémoire ne transmettent pas de données.

3. Tableau de mémoire selon la revendication 1, **caractérisé en ce que** le second terminal du premier dispositif de switch (Tr1) est relié directement au premier terminal du second dispositif de switch (Tr2).

4. Tableau de mémoire selon la revendication 1, **caractérisé en ce que** le premier dispositif de switch (Tr1) et le second dispositif de switch (Tr2) sont nMOSFETSs, où les premiers terminaux du premier dispositif de switch (Tr1) et du second dispositif de switch (Tr2) sont des terminaux de drain, les terminaux de commande du premier dispositif de switch (Tr1) et du second dispositif de switch (Tr2) sont des terminaux de porte, et les second terminaux du premier dispositif de switch (Tr1) et du second dispositif de switch (Tr2) sont des terminaux de source.

5. Tableau de mémoire selon la revendication 1, **caractérisé en ce que** le premier dispositif de switch (Tr1) et le second dispositif de switch (Tr2) sont pMOSFETSs, où les premiers terminaux du premier dispositif de switch (Tr1) et du second dispositif de switch (Tr2) sont des terminaux de source, les terminaux de commande du premier dispositif de switch (Tr1) et du second dispositif de switch (Tr2) sont des terminaux de porte, et les second terminaux du premier dispositif de switch (Tr1) et du second dispositif de switch (Tr2) sont des terminaux de drain.

6. Tableau de mémoire selon la revendication 1, **caractérisé en ce qu'**une cellule de mémoire (odd1-odd4, even1-even4) est prévue à chaque intersection des lignes de bits (BL1-BL4) et des lignes de mots (WL1, WL2).
